# EUROPEAN PATENT APPLICATION

(11) **EP 4 538 755 A1**
(43) Date of publication of application: **16.04.2025**
(21) Application number: 23843318.9
(22) Date of filing: 18.07.2023
(51) Int. Cl.: G02B 5/20, C08J 5/18, C08K 7/02, G02F 1/1335, G09F 9/00, H10K 59/00, H10K 50/00

(54) **OPTICAL FILM AND DISPLAY DEVICE COMPRISING SAME**

(30) Priority: 18.07.2022 KR 20220088348; 17.07.2023 KR 20230092481
(71) Applicant: Kolon Industries, Inc., Seoul 07793 (KR)
(72) Inventor: YANG, Jong Won, Seoul 07793 (KR); KWON, Kyung Wook, Seoul 07793 (KR); KIM, Han Sol, Seoul 07793 (KR); SHIN, In Ho, Seoul 07793 (KR); PARK, Hyo Jun, Seoul 07793 (KR)
(74) Representative: Ter Meer Steinmeister & Partner
(86) International application number: PCT/KR2023/010260
(87) International publication number: WO 2024/019472

(57) **Abstract**

An embodiment of the present invention provides an optical film and display device comprising the optical film, the optical film comprising a light-transmissive matrix containing a polymer resin and nanowires dispersed in the light-transmissive matrix, wherein: the polymer resin comprises at least on of an imide repeating unit and an amide repeating unit; the nanowires comprise crystallites; and the crystallites are linear.

## Description

### [Technical Field]

The present disclosure relates to an optical film and a display device including the same and more particularly, to an optical film having excellent mechanical properties.

### [Background Art]

Recently, the use of an optical film instead of glass as a cover window of a display device has been considered with the goal of reducing thickness and weight and increasing the flexibility of the display device. In order for the optical film to be usable as a cover window of a display device, the optical film needs to have superior optical properties and excellent mechanical properties. For example, an optical film needs to have properties such as excellent strength, hardness, abrasion resistance, and flexibility.

Nanowire may be added as fillers in order to impart desired physical properties to an optical film requiring various physical properties. The nanowire may vary depending on physical properties required for the optical film.

### [Disclosure]

### [Technical Problem]

Therefore, the present disclosure has been made in view of the above problems, and it is one aspect of the present disclosure to provide an optical film that includes a fiber-shape or filament-shape nanowire dispersed in a light-transmitting matrix.

It is another aspect of the present disclosure to provide an optical film that includes a fiber-shape or filament-shape nanowire dispersed in a light-transmitting matrix, wherein the fiber-shape or filament-shape nanowire engages polymer chains constituting the light-transmitting matrix, to improve the stability and alignment characteristics of the polymer chains.

It is another aspect of the present disclosure to provide an optical film that includes a fiber-shape or filament-shape nanowire dispersed in a light-transmitting matrix, to provide excellent elongation and restoration rate.

It is another aspect of the present disclosure to provide a display device including the optical film.

### [Technical Solution]

In accordance with one aspect of the present disclosure, provided is an optical film including a light-transmitting matrix including a polymer resin and a nanowire dispersed in the light-transmitting matrix, wherein the polymer resin includes at least one of an imide repeating unit and an amide repeating unit, and the nanowire contains a crystallite, wherein the crystallite is linear and the optical film has at least one of structures represented by Formulas 1, 2, and 3 below. 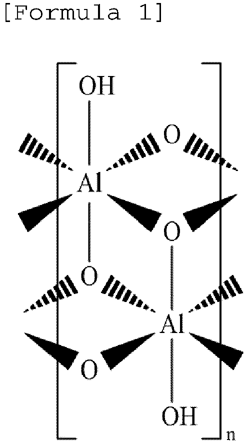 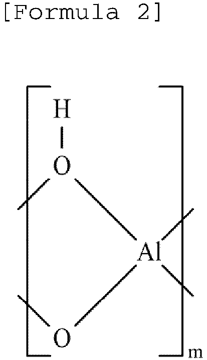 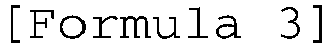 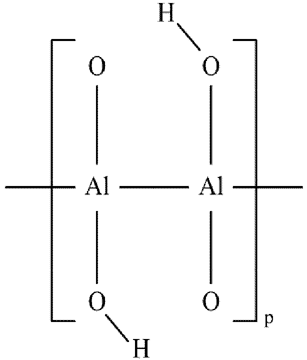 wherein n is in the range of 50 to 10,000, m is in the range of 50 to 10,000, and p is in the range of 100 to 20,000.

In accordance with another aspect of the present disclosure, provided is a display device including a display panel and the optical film disposed on the display panel.

### [Advantageous Effects]

According to one embodiment of the present disclosure, the nanowire included in the optical film has a fiber-shape or filament-shape and may engage polymer chains constituting the light-transmitting matrix. As a result, mechanical strength of the optical film may be improved.

According to one embodiment of the present disclosure, an optical film including a fiber-shape nanowire may have excellent mechanical properties as well as excellent optical properties. The optical film according to an embodiment of the present disclosure has excellent optical and mechanical properties, thus being useful as a cover window of a display device.

### [Description of Drawings]

FIG. 1 is a schematic diagram illustrating an optical film according to an embodiment of the present disclosure.
FIG. 2 is a cross-sectional view illustrating a part of a display device according to another exemplary embodiment of the present disclosure.
FIG. 3 is an enlarged cross-sectional view illustrating part "P" in FIG. 2.

### [Best Mode]

Hereinafter, embodiments of the present disclosure will be described in detail with reference to the accompanying drawings. However, the following embodiments are illustratively provided merely for clear understanding of the present disclosure and do not limit the scope of the present disclosure.

The shapes, sizes, ratios, angles, and numbers disclosed in the drawings for describing embodiments of the present disclosure are merely examples, and the present disclosure is not limited to the illustrated details. Like reference numerals refer to like elements throughout the present specification. In the following description, when a detailed description of relevant known functions or configurations is determined to unnecessarily obscure important points of the present disclosure, the detailed description will be omitted.

In the case in which a term such as "comprise", "have", or "include" is used in the present specification, another part may also be present, unless "only" is also used. Terms in a singular form may include the plural meanings, unless noted to the contrary. Also, in construing an element, the element is to be construed as including an error range, even if there is no explicit description thereof.

In describing a positional relationship, for example, when the positional relationship is described using "on", "above", "below", or "next to", the case of no contact therebetween may be included, unless "immediately" or "directly" is used.

Spatially relative terms, such as "below", "beneath", "lower", "above", and "upper", may be used herein to describe the relationship between a device or element and another device or element, as shown in the figures. It will be understood that spatially relative terms are intended to encompass different orientations of a device during the use or operation of the device, in addition to the orientation depicted in the figures. For example, if a device in one of the figures is turned upside down, elements described as "below" or "beneath" other elements would then be positioned "above" the other elements. The exemplary term "below" or "beneath" can, therefore, encompass the meanings of both "below" and "above". In the same manner, the exemplary term "above" or "upper" can encompass the meanings of both "above" and "below".

In describing temporal relationships, for example, when a temporal order is described using "after", "subsequent", "next", or "before", the case of a non-continuous relationship may be included, unless "immediately" or "directly" is used.

It will be understood that, although the terms "first", "second", etc. may be used herein to describe various elements, these elements are not limited by these terms. These terms are only used to distinguish one element from another. Therefore, a first element could be termed a second element within the technical idea of the present disclosure.

It should be understood that the term "at least one" includes all combinations related with one or more items. For example, "at least one among a first element, a second element, and a third element" may include all combinations of two or more elements selected from among the first, second, and third elements, as well as each of the first, second, and third elements.

Features of various embodiments of the present disclosure may be partially or completely integrated or combined with each other, and may be variously interoperated with each other and driven technically. The embodiments of the present disclosure may be carried out independently from each other, or may be carried out together in an interrelated manner.

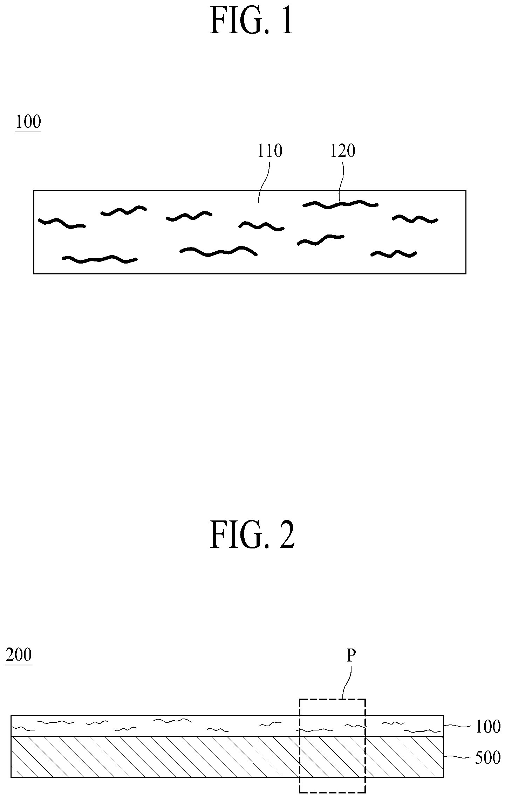

FIG. 1 is a schematic diagram illustrating an optical film 100 according to an embodiment of the present disclosure. According to one embodiment of the present disclosure, a film having light transmittance is referred to as an "optical film 100".

The optical film 100 according to an embodiment of the present disclosure includes a light-transmitting matrix 110 and a nanowire 120 dispersed in the light-transmitting matrix 110.

The light-transmitting matrix 110 may be light-transmissive. According to an embodiment of the present disclosure, the light-transmitting matrix 110 may be flexible. For example, the optical film according to an embodiment of the present disclosure may be bendable, foldable, or rollable. As a result, the optical film 100 according to an embodiment of the present disclosure may be light-transmissive and may be bendable, foldable, or rollable.

According to an embodiment of the present disclosure, the light-transmitting matrix 110 may include a polymer resin. The polymer resin included in the light-transmitting matrix 110 may include at least one of an imide repeating unit and an amide repeating unit.

The polymer resin according to an embodiment of the present disclosure may be prepared from monomeric ingredients including dianhydrides and diamines. Specifically, the polymer resin may include an imide repeating unit formed by dianhydride and diamine.

However, the polymer resin according to an embodiment of the present disclosure is not limited thereto, and the polymer resin may be produced from monomeric ingredients including a dicarbonyl compound in addition to dianhydride and diamine. The polymer resin according to an embodiment of the present disclosure may have an imide repeating unit and an amide repeating unit. For example, the polymer resin having an imide repeating unit and an amide repeating unit may be a polyamide-imide resin.

According to one embodiment of the present disclosure, the polymer resin may include a polyimide-based polymer. Examples of the polyimide-based polymer may include polyimide polymers, polyamide polymers, polyamide-imide polymers and the like. The polymer resin according to an embodiment of the present disclosure may be formed of, for example, a polyimide-based polymer resin.

The light-transmitting matrix 110 may have a thickness sufficient for the optical film 100 to protect the display panel. For example, the light-transmitting matrix 110 may have a thickness of 10 to 100 µm. The thickness of the light-transmitting matrix 110 may be the same as that of the optical film 100.

The optical film 100 according to an embodiment of the present disclosure includes nanowire 120. Optical characteristics of the optical film 100 may be improved by light scattering caused by the nanowire 120.

Hereinafter, the nanowire 120 included in the optical film 100 and a crystallite included in the nanowire 120 will be described in more detail.

According to one embodiment of the present disclosure, the nanowire 120 may include a crystallite. A crystallite is also called a "crystal grain" and means each of a plurality of fine crystal units that constitutes a single crystal. According to one embodiment of the present disclosure, the crystallite may include aluminum. More specifically, the crystallite may include aluminum, oxygen and hydrogen.

For example, the crystallite included in the nanowire 120 may include aluminum oxide hydroxide-based crystallite. The aluminum oxide hydroxide-based material is, for example, Boehmite, and Boehmite may be represented by γ-AlO(OH).

According to one embodiment of the present disclosure, the crystallite may be linear and have at least one of the structures represented by Formulas 1, 2 and 3 below.

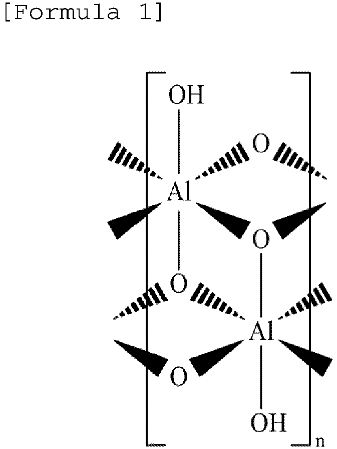

The unit structure expressed in parentheses ([ ]) in Formula 1 may be referred to as a unit crystal.

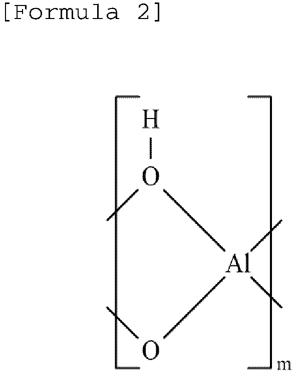

The unit structure expressed in parentheses ([ ]) in Formula 2 may be referred to as a unit crystal.

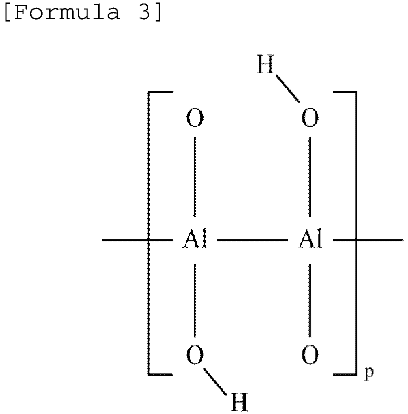

The unit structure expressed in parentheses ([ ]) in Formula 3 may be referred to as a unit crystal.

Herein, n in Formula 1, m in Formula 2, and p in Formula 3 represent the number of repeating units. In order to obtain crystallite and nanowire 120 with appropriate lengths, n in Formula 1, m in Formula 2, and p in Formula 3 may be adjusted.

According to one embodiment of the present disclosure, n in Formula 1 ranges from 50 to 10,000, m in Formula 2 ranges from 50 to 10,000, and p in Formula 3 ranges from 100 to 20,000. When n, m, and p are determined within these ranges, the nanowire 120 may have a length of about 200 nm to about 4,000 nm.

When n is less than 50, it is difficult for the crystallite to have a sufficient length. When the length of the crystallite is not great, it is difficult to obtain a sufficient length of the nanowire 120. Accordingly, the function of the nanowire 120 to engage (or link, or connect) the polymer chains within the light-transmitting matrix 110 may not be sufficiently obtained.

When n is greater than 10,000, the length of the crystallite may be excessive. As a result, the length of the nanowire 120 may be excessive and the dispersibility of the nanowire 120 may deteriorate. Accordingly, aggregation of the nanowire 120 may occur within the light-transmitting matrix 110.

When m is less than 50, it is difficult to impart a sufficient length to the crystallite. When the length of the crystallite is not great, it is difficult to increase the length of the nanowire 120. Accordingly, the function of the nanowire 120 to engage polymer chains in the light-transmitting matrix 110 may not be sufficiently obtained.

When m is greater than 10,000, the length of crystallite may be excessively great. As a result, the length of the nanowire 120 may be excessive and the dispersibility of the nanowire 120 may deteriorate. Accordingly, aggregation of the nanowire 120 may occur within the light-transmitting matrix 110.

When p is less than 100, it is difficult to impart a sufficient length to crystallite. When the length of the crystallite is not great, it is difficult to increase the length of the nanowire 120. Accordingly, the function of the nanowire 120 to engage the polymer chains within the light-transmitting matrix 110 may not be sufficiently obtained.

When p is greater than 20,000, the length of crystallite may be excessively great. As a result, the length of the nanowire 120 may be excessive and the dispersibility of the nanowire 120 may deteriorate. Accordingly, aggregation of the nanowire 120 may occur within the light-transmitting matrix 110.

More specifically, n in Formula 1 may range from 2,000 to 8,000. Within this range, the nanowire 120 has a length of about 1,000 to 4,000 nm and thus can fully exert the function of engaging polymer chains and have excellent dispersibility. Accordingly, the optical film 100 having uniform optical properties can be manufactured.

m in Formula 2 may range from 2,000 to 8,000. Within this range, the nanowire 120 has a length of about 1,000 to 4,000 nm and thus can fully exert the function of engaging polymer chains and have excellent dispersibility. Accordingly, the optical film 100 having uniform optical properties can be manufactured.

p in Formula 3 may range from 4,000 to 16,000. Within this range, the nanowire 120 has a length of about 1,000 to 4,000 nm and thus can fully exert the function of engaging polymer chains and have excellent dispersibility. Accordingly, the optical film 100 having uniform optical properties can be manufactured.

When the structure of the crystallite is expanded for better understanding of the structure of the crystallite, the crystallite may be represented by any one of Formulas 4, 5 and 6.

The crystallite of Formula 1 may be represented by, for example, Formula 4 below. Formula 4 below corresponds to the structure of Formula 1 wherein n is 5.

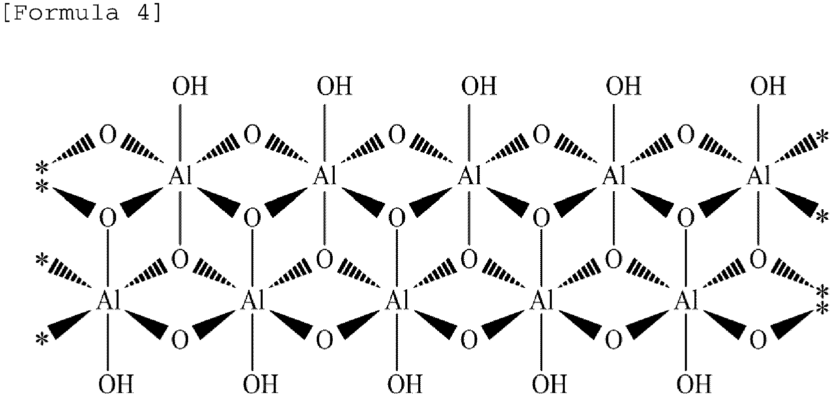

The crystallite of Formula 2 may be represented by, for example, Formula 5 below. Formula 5 below corresponds to the structure of Formula 2 wherein m is 4.

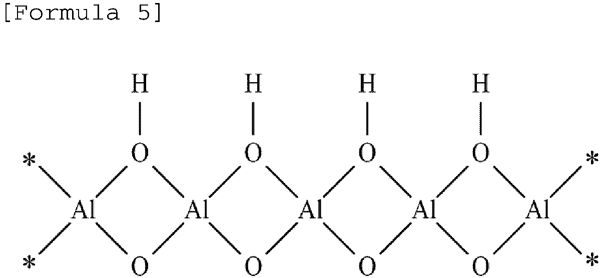

The crystallite of Formula 3 may be represented by, for example, Formula 6 below. Formula 6 below corresponds to the structure of Formula 3 wherein p is 3.

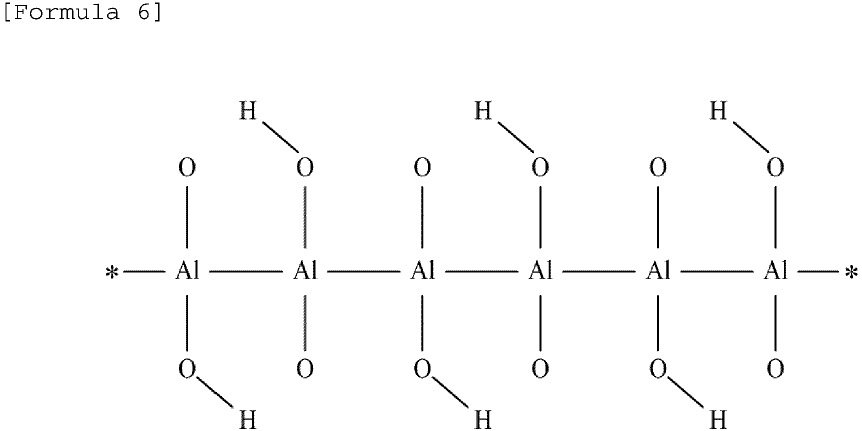

In Formulas 4, 5 and 6, "*" represents a bonding site.

According to one embodiment of the present disclosure, the nanowire 120 may have a laminate including at least two or more crystallites.

According to one embodiment of the present disclosure, a plurality of crystallites may be stacked in a radial direction to form a laminate. According to one embodiment of the present disclosure, a structure formed by stacking a plurality of crystallites in a radial direction is referred to as a "laminate".

According to one embodiment of the present disclosure, two or more crystallites in the laminate may be bonded by hydrogen bonding.

According to an embodiment of the present disclosure, a hydrogen bond may be made via oxygen (O).

According to one embodiment of the present disclosure, for example, H of an -OH group bonded to an aluminum atom of one crystallite may be hydrogen-bonded with O (oxygen) bonded to an aluminum atom of another crystallite to form a laminate.

According to one embodiment of the present disclosure, the laminate may include 2 to 40 crystallites.

According to one embodiment of the present disclosure, 2 to 40 crystallites may be stacked. Stacked crystallites may be included in the laminate.

According to one embodiment of the present disclosure, when crystallites in the range of 2 to 40 are stacked and included in the laminate, the nanowire 120 having an appropriate diameter can be obtained.

When the crystallites are not stacked, the diameter of the nanowire 120 is excessively small and thus the stability of the nanowire 120 may deteriorate. When more than 40 crystallites are stacked, the diameter of the nanowire 120 is excessively great and it may be difficult to impart a fiber-shape to the nanowire 120.

According to one embodiment of the present disclosure, the laminate may include at least one of structures represented by Formulas 7, 8, and 9 below.

According to one embodiment of the present disclosure, when the crystallites including the structure represented by Formula 4 are stacked, the laminate may include, for example, the structure represented by Formula 7 below.

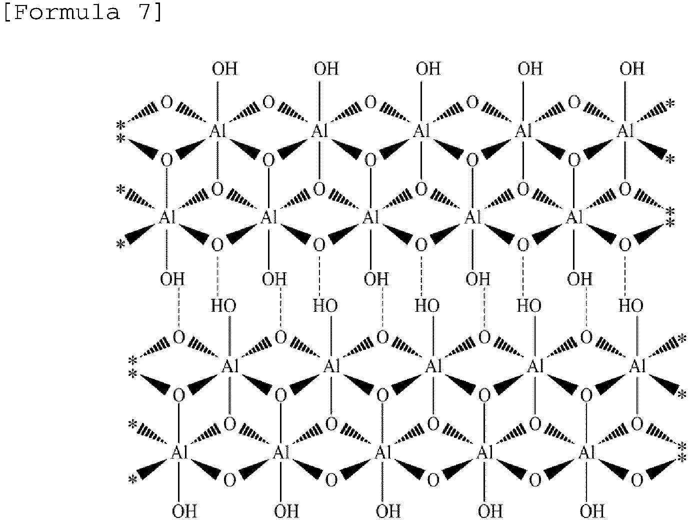

According to one embodiment of the present disclosure, when crystallites including a structure represented by Formula 5 are stacked, the laminate may include, for example, a structure represented by Formula 8 below.

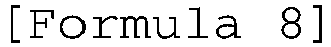

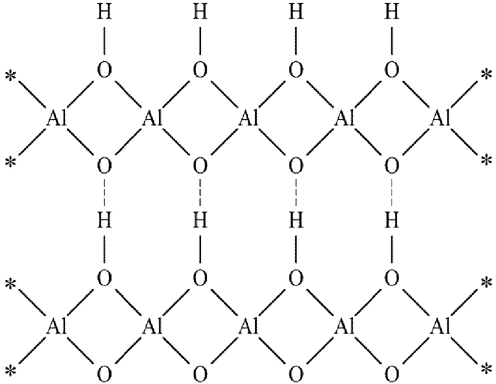

According to one embodiment of the present disclosure, when crystallites including a structure represented by Formula 6 are stacked, the laminate may include, for example, a structure represented by Formula 9 below.

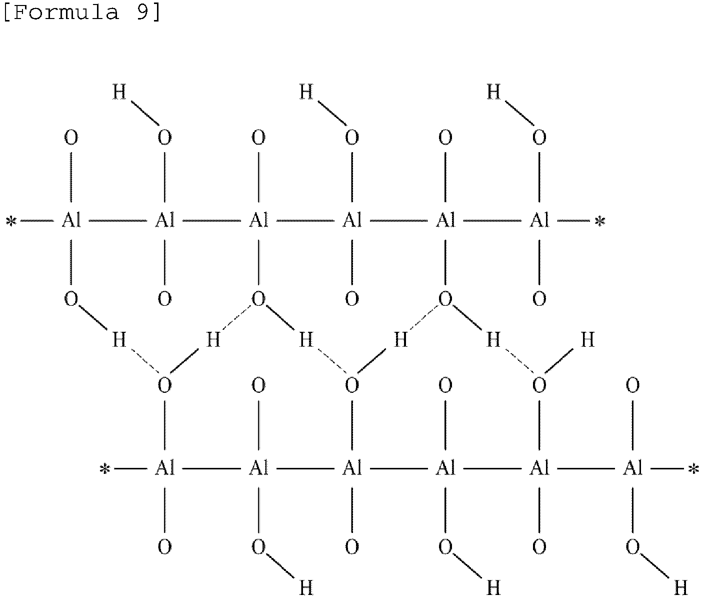

In Formulas 7, 8 and 9, "*" indicates a bonding site and a dotted line indicates a hydrogen bond between crystallites.

According to one embodiment of the present disclosure, the nanowire 120 may have a fiber-shape. For example, a fiber may refer to a material that is much longer in length than in diameter. The fiber may refer to a thin and long thread-like material. The fiber may refer to a material having a linear structure. The fiber may also refer to a long and bendable material.

According to one embodiment of the present disclosure, the nanowire 120 may have a fiber-shape including at least one of crystallites represented by Formulas 1, 2, and 3. According to one embodiment of the present disclosure, the length of the nanowire 120 may be two or more times the diameter.

According to one embodiment of the present disclosure, the nanowire 120 is aligned in parallel to the polymer resin included in the light-transmitting matrix 110. For example, the nanowire 120 may be bonded to the main chain of the polymer resin through a secondary bond such as a hydrogen bond or a dipole moment-based bond, and may be aligned in parallel to the polymer resin in a main chain direction.

According to one embodiment of the present disclosure, the nanowire 120 may function to engage polymer chains of the polymer resin included in the light-transmitting matrix 110. As a result, the stability and alignment characteristics of the polymer chains are improved, so that the mechanical properties of the light-transmitting matrix 110 may be improved and the optical film 100 may also be improved.

According to one embodiment of the present disclosure, when the diameter of the nanowire 120 is defined as "A" and the length of the nanowire 120 is defined as "B", the ratio of B/A may be in the range of 10 to 500.

When the ratio (B/A) of the length to the diameter of the nanowire 120 is less than 10, the nanowire 120 is not long enough and thus does not sufficiently exert the function of engaging polymer chains, and the effects of improving stability and alignment characteristics of the polymer chains.

When the ratio (B/A) of the length to the diameter of the nanowire 120 is higher than 500, the nanowire 120 is excessively long, thus causing deterioration in dispersibility and aggregation in the light-transmitting matrix 110. As a result, the optical film 100 may have decreased light transmittance, increased haze, and deteriorated optical properties. In addition, the mechanical strength of the optical film 100 may be lowered in the portion where the aggregation of the nanowire 120 occurs, thus leading to deterioration in mechanical properties of the optical film 100.

According to one embodiment of the present disclosure, the ratio (B/A) of the length to the diameter of the nanowire 120 may be, for example, in the range of 50 to 500. More specifically, the ratio (B/A) of the length to the diameter of the nanowire 120 may be, for example, in the range of 100 to 400, and may be in the range of 200 to 400. The ratio (B/A) of length to diameter of the nanowire 120 may be in the range of 300 to 400. According to one embodiment of the present disclosure, the nanowire 120 may have a diameter of 2 nm to 10 nm and a length of 200 nm to 4,000 nm.

According to one embodiment of the present disclosure, the diameter and length of the nanowire 120 may be measured by transmission electron microscopy (TEM).

When the diameter of the nanowire 120 is less than 2 nm, the stability of the nanowire 120 may be lowered, the nanowire 120 may be broken or crumble, and thus the optical film 100 may be contaminated and haze may be increased. When the diameter of the nanowire 120 is higher than 10 nm, a portion of the nanowire 120 may protrude from the surface of the optical film 100 and the function of the nanowire 120 to engage polymer chains may deteriorate.

When the length of the nanowire 120 is less than 200 nm, the function of the nanowire 120 to engage polymer chains may not be sufficiently obtained. When the length of the nanowire 120 is higher than 4,000 nm, the dispersibility of the nanowire 120 may decrease, thus causing aggregation of the nanowire 120 in the light-transmitting matrix 110.

According to one embodiment of the present disclosure, the length of the nanowire 120 may be controlled by growth conditions of the nanowire 120 or post-treatment of the nanowire 120. For example, the length of the nanowire 120 may be appropriately adjusted through temperature control during growth of the nanowire 120. In addition, ultrasound or other energy may be applied to the nanowire 120 grown to a predetermined length, so that the nanowire 120 can be cut to an appropriate length.

According to one embodiment of the present disclosure, the nanowire 120 may be surface-treated. For example, the nanowire 120 may be a fiber surface-treated with an organic compound having an alkoxy group.

According to one embodiment of the present disclosure, the content of the nanowire 120 may be in the range of 1 to 40% by weight with respect to the total weight of the optical film 100.

When the content of the nanowire 120 is less than 1% by weight with respect to the total weight of the optical film 100, the effect of improving the light transmittance of the optical film 100 may not be obtained due to insignificant light scattering effect by the nanowire 120 and the effect of improving the mechanical properties of the optical film 100 may be insignificant since the function of the nanowire 120 to engage polymer chains is not sufficiently obtained.

Meanwhile, when the content of the nanowire 120 is higher than 40% by weight based on the total weight of the optical film 100, the dispersibility of the nanowire 120 may be lowered, the haze of the optical film 100 may be lowered, the aggregation of the nanowire 120 may occur due to the excessive amount thereof, and the aggregated nanowire 120 may block light, thus decreasing light transmittance of the optical film 100.

More specifically, the content of the nanowire 120 with respect to the total weight of the optical film 100 may be adjusted to 3 to 40% by weight, 5 to 40% by weight, 5 to 30% by weight, or 5 to 20% by weight.

According to one embodiment of the present disclosure, an increase in haze and a decrease in light transmittance of the optical film 100 can be prevented, and the mechanical strength of the optical film 100 can be improved by controlling the diameter, length and content of the nanowire 120 and improving the dispersion method.

According to an embodiment of the present disclosure, the optical film 100 may have a machine direction (MD) and a transverse direction (TD).

The direction in which mechanical treatment is performed on the film is called "machine direction (MD)", and the direction perpendicular to the MD is called "transverse direction (TD)". For example, when the film is stretched, a direction parallel to the direction of stretching may be the machine direction (MD), when the film is cast, the direction parallel to the direction of casting may be the machine direction (MD), and when the film is wound through a roller, a direction parallel to the direction of winding may be the machine direction (MD).

According to one embodiment of the present disclosure, the machine direction (MD) is a direction parallel to the casting direction of the optical film 100 in the manufacturing process. The machine direction (MD) may also be referred to as a longitudinal direction. The TD is a direction perpendicular to the MD. The transverse direction (TD) may also be referred to as a "width direction".

The optical film 100 according to an embodiment of the present disclosure may have an elongation of 5 to 40%.

According to one embodiment of the present disclosure, the elongation (%) of the optical film 100 may be obtained by measuring the elongation in the MD and the elongation in the TD in accordance with ASTM D885 and then calculating the average thereof.

When the elongation (%) is less than 5%, the optical film 100 may be unsuitable as a substrate material or protective layer for foldable displays. When the elongation (%) is higher than 40%, restoration may be difficult due to excessive deformation.

The optical film 100 according to an embodiment of the present disclosure may have a restoration rate (nIT, %) of 66 or more based on a thickness of 50 µm.

According to an embodiment of the present disclosure, the restoration rate (nIT, %) of the optical film 100 may be obtained by calculating the degree of restoration of the optical film 100 after removing the optical film 100 which has been pressed with a diamond quadrangular pyramid having a diagonal angle of 136° in accordance with ISO 14577-1.

When the restoration rate (nIT) is less than 66, the restoring force of the optical film 100 is insufficient and thus fold or pressing marks may remain on the optical film 100.

The optical film 100 according to an embodiment of the present disclosure may have a modulus of elasticity (EIT) of 3,800 MPa or more based on a thickness of 50 um.

According to an embodiment of the present disclosure, the modulus of elasticity (EIT, indentation modulus) of the optical film 100 is measured using a nanoindenter in accordance with ISO 14577-1 and 12 mN/12s/Creep 5s/24°C, 40 RH% conditions. The nanoindenter herein used was an HM-2000 from Fischer.

According to one embodiment of the present disclosure, the optical film 100 may include fiber-shape nanowire 120 and may have a high modulus of elasticity (EIT).

According to one embodiment of the present disclosure, the fiber-shape nanowire 120 engage the polymers constituting the light-transmitting matrix 110, in particular, polymer chains, so that the optical film 100 has an elongation of about 5 to 40% and a relatively great restoration rate (nIT) of 66 or more.

According to one embodiment of the present disclosure, the optical film 100 may have a yellowness index of 3 or less.

According to one embodiment of the present disclosure, even if the optical film 100 includes the nanowire 120 having a ratio of length to diameter (B/A) in the range of 10 to 500, the nanowire 120 is uniformly dispersed in the optical film 100 and has a degree of orientation within a certain range, so that the yellowness index of the optical film 100 is not greatly increased and the optical properties are not deteriorated. More specifically, the optical film 100 may include a nanowire 120 having a ratio of length to diameter (B/A) within the range of 100 to 400. Even in this case, the yellowness index of the optical film 100 is not greatly increased and the optical properties are not deteriorated.

According to one embodiment of the present disclosure, the optical film 100 may have a haze of 2% or less, and more specifically, may have a haze of 1% or less. Although the nanowire 120 included in the light-transmitting matrix 110 is relatively long, the diameter of the nanowire 120 is small, so that an increase in haze caused by the nanowire 120 can be prevented. In particular, although the fiber-shape nanowire 120 is used, a haze of 2% or less, for example, a haze of 1% or less can be imparted to the optical film 100 by adjusting the diameter, length, and the ratio of length to diameter (B/A) and the content ratio of the nanowire 120 dispersed in the light-transmitting matrix 110, and improving the dispersibility of the nanowire 120.

In addition, according to an embodiment of the present disclosure, the optical film 100 may have a light transmittance of 88% or more. Although the length of the nanowire 120 included in the light-transmitting matrix 110 is relatively great, the diameter of the nanowire 120 is small, so that decrease in light transmittance by the nanowire 120 can be prevented. In particular, although the fiber-shape nanowire 120 is used, a light transmittance of 88% or more can be imparted to the optical film 100 by adjusting the diameter, length, the ratio of length to diameter (B/A) and content ratio of the nanowire 120 dispersed in the light-transmitting matrix 110, and improving the dispersibility of the nanowire 120.

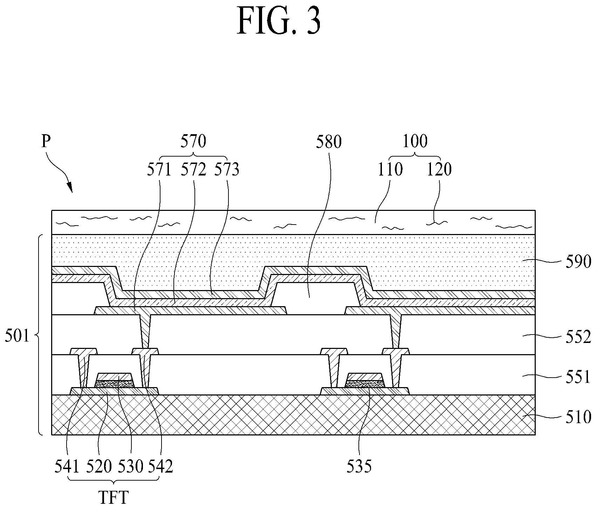

FIG. 2 is a cross-sectional view illustrating a part of a display device 200 according to another embodiment of the present disclosure and FIG. 3 is an enlarged cross-sectional view of "P" in FIG. 2.

Referring to FIG. 2, the display device 200 according to another embodiment of the present disclosure includes a display panel 501 and an optical film 100 on the display panel 501.

Referring to FIGs. 2 and 3, the display panel 501 includes a substrate 510, a thin film transistor TFT on the substrate 510, and an organic light-emitting device 570 connected to the thin film transistor TFT. The organic light-emitting device 570 includes a first electrode 571, an organic light-emitting layer 572 on the first electrode 571, and a second electrode 573 on the organic light-emitting layer 572. The display device 200 shown in FIGs. 2 and 3 is an organic light-emitting display device.

The substrate 510 may be formed of glass or plastic. Specifically, the substrate 510 may be formed of plastic such as a polyimide-based resin or an optical film. Although not shown, a buffer layer may be disposed on the substrate 510.

The thin film transistor TFT is disposed on the substrate 510. The thin film transistor TFT includes a semiconductor layer 520, a gate electrode 530 that is insulated from the semiconductor layer 520 and at least partially overlaps the semiconductor layer 520, a source electrode 541 connected to the semiconductor layer 520, and a drain electrode 542 that is spaced apart from the source electrode 541 and is connected to the semiconductor layer 520.

Referring to FIG. 3, a gate insulating layer 535 is disposed between the gate electrode 530 and the semiconductor layer 520. An interlayer insulating layer 551 may be disposed on the gate electrode 530, and a source electrode 541 and a drain electrode 542 may be disposed on the interlayer insulating layer 551.

A planarization layer 552 is disposed on the thin film transistor TFT to planarize the top of the thin film transistor TFT.

A first electrode 571 is disposed on the planarization layer 552. The first electrode 571 is connected to the thin film transistor TFT through a contact hole provided in the planarization layer 552.

A bank layer 580 is disposed on the planarization layer 552 in a part of the first electrode 571 to define pixel areas or light-emitting areas. For example, the bank layer 580 is disposed in the form of a matrix at the boundaries between a plurality of pixels to define the respective pixel regions.

The organic light-emitting layer 572 is disposed on the first electrode 571. The organic light-emitting layer 572 may also be disposed on the bank layer 580. The organic light-emitting layer 572 may include one light-emitting layer, or two or more light-emitting layers stacked in a vertical direction. Light having any one color among red, green, and blue may be emitted from the organic light-emitting layer 572, and white light may be emitted therefrom.

The second electrode 573 is disposed on the organic light-emitting layer 572.

The first electrode 571, the organic light-emitting layer 572, and the second electrode 573 may be stacked to constitute the organic light-emitting device 570.

Although not shown, when the organic light-emitting layer 572 emits white light, each pixel may include a color filter for filtering the white light emitted from the organic light-emitting layer 572 based on a particular wavelength. The color filter is formed in the light path.

A thin-film encapsulation layer 590 may be disposed on the second electrode 573. The thin-film encapsulation layer 590 may include at least one organic layer and at least one inorganic layer, and the at least one organic layer and the at least one inorganic layer may be alternately disposed.

The optical film 100 is disposed on the display panel 501 having the stack structure described above. The optical film 100 includes a light-transmitting matrix 110 and a nanowire 120 dispersed in the light-transmitting matrix 110.

Hereinafter, a method of manufacturing an optical film 100 according to another embodiment of the present disclosure will be described.

The method of manufacturing an optical film 100 according to an embodiment of the present disclosure includes primarily dispersing the nanowire 120 in a resin solution for forming a light-transmitting matrix 110 to prepare a first mix solution, improving the alignment characteristics of the nanowire 120 in the first mixture solution, and casting the first mixture solution to produce a cast film.

According to one embodiment of the present disclosure, a polyimide-based resin solution may be used as the resin solution for forming the light-transmitting matrix 110.

More specifically, the method of manufacturing the optical film 100 according to an embodiment of the present disclosure includes preparing a polyimide-based resin powder, dissolving the polyimide-based resin powder in a first solvent to obtain a polyimide-based resin solution, dispersing the nanowire 120 in a second solvent to prepare a nanowire dispersion, and mixing the nanowire dispersion with the polyimide-based resin solution to prepare a first mix solution.

DMAc (N,N-dimethylacetamide) may be used as the first solvent. DMAc (N,N-dimethylacetamide) or methyl ethyl ketone (MEK) may be used as the second solvent, but one embodiment of the present disclosure is not limited thereto, and other known solvents as the first solvent and the second solvent may be used.

The fiber-shape nanowire 120, for example, a fiber-shape nanowire 120 having a high aspect ratio has a great length compared to the diameter thereof and thus may readily aggregate or agglomerate in the light-transmitting matrix 110. Therefore, the nanowire 120 requires excellent dispersibility in the first mix solution.

According to one embodiment of the present disclosure, to improve the dispersibility of the nanowire 120, for example, p-toluene sulfonic acid (PTSA) may be used as an additive, but one embodiment of the present disclosure is not limited thereto and other known additives may be used to improve the dispersibility of the nanowire 120.

According to one embodiment of the present disclosure, in order to improve the dispersibility of the nanowire 120, the pH of the first mix solution may be adjusted. For example, the pH of the first mix solution may be adjusted to the range of 5 to 7. Accordingly, aggregation or agglomeration of the nanowire 120 may be prevented.

Next, the first mix solution is cast, dried and heat-treated to form an optical film 100. According to one embodiment of the present disclosure, the film formed by casting the first mix solution may be referred to as a "cast film" and the film produced by drying and heat-treating the cast film may be referred to as an "optical film 100". The cast film can be referred to as an "uncured film".

In order to improve the orientation of the nanowire 120, casting may be performed by bar coating.

According to one embodiment of the present disclosure, the orientation direction and degree of the nanowire 120 may be varied by adjusting the pressure applied to the cast film formed by casting.

In addition, convection may be prevented during drying and heat treatment of the cast film formed by casting, so that the nanowire 120 may be oriented in a certain direction.

Specifically, when convection is generated inside the cast film that is dried using heat, the orientation of the nanowire 120 may decrease. Thus, the cast film may be allowed to be dried slowly to prevent convection. For example, drying of the cast film may be performed while raising the temperature from 80°C to 120°C at a rate of 1°C/1 minute. When drying is performed over a certain level, the orientation of the nanowire 120 may be fixed.

Hereinafter, the present disclosure will be described in more detail with reference to preparation examples and examples. However, the following preparation examples and examples should not be construed as limiting the scope of the present disclosure.

### <Preparation Example 1: Preparation of polymer-imide-based polymer solid>

776.655 g of N,N-dimethylacetamide (DMAc) was charged in a 1L reactor equipped with a stirrer, a nitrogen injector, a dropping funnel, a temperature controller, and a cooler while the reactor was purged with nitrogen. Then, the temperature of the reactor was adjusted to 25°C, 54.439 g (0.17 mol) of bis(trifluoromethyl)benzidine (TFDB) was dissolved therein and the temperature of the solution was maintained at 25°C. 15.005 g (0.051 mol) of biphenyltetracarboxylic acid dianhydride (BPDA) was further added thereto and completely dissolved therein by stirring for 3 hours, and 22.657 g (0.051 mol) of 4,4'-(hexafluoroisopropylidene)diphthalic anhydride (6FDA) was further added thereto and completely dissolved therein. The reactor temperature was lowered to 10°C, and 13.805 g (0.068 mol) of terephthaloyl chloride (TPC) was further added thereto and allowed to react at 25°C for 12 hours to obtain a polymer solution having a solid content of 12 wt%.

17.75 g of pyridine and 22.92 g of acetic anhydride were added to the obtained polymer solution, stirred for 30 minutes, stirred again for 1 hour at 70°C, and allowed to cool to room temperature. 20L of methanol was added to the obtained polymer solution to precipitate a solid and the precipitated solid was filtered, pulverized, washed with 2L of methanol, and dried under vacuum at 100°C for 6 hours to prepare a polyimide-based polymer solid as a powder. The prepared polyimide-based polymer solid was a polyamide-imide polymer solid.

### <Example 1>

850 g of DMAc (first solvent) was added to a 1 L reactor and the reactor was stirred for a certain period of time while the temperature of the reactor was maintained at 10°C. Then, 127 g of polyamide-imide (polyimide-based resin powder) prepared as the solid powder in Preparation Example 1 was added to the reactor, stirred for 1 hour, and heated to 25°C to prepare a liquid polyimide-based resin solution.

An alumina fiber dispersion was used as the dispersion added to the nanowire 120. Specifically, a nanowire 120 having an average particle diameter of about 4 nm and an average length of about 1,600 nm was used in a DMAc (N,N-dimethylacetamide, second solvent) solution. As the nanowire 120, an aluminum-based nanowire having a laminate structure represented by Formula 7 was used. The nanowire was used as a dispersion and the content of the nanowire was 10% by weight based on the total weight of the solid content (polyimide-based resin component + nanowire).

Specifically, another 1L reactor was filled with the nanowire dispersion, the temperature of the reactor was maintained at 25°C, and the prepared liquid polyimide-based resin solution was slowly added thereto for 1 hour using a cylinder pump to obtain a first mix solution containing the nanowire dispersion and the polyimide-based resin solution. Here, the nanowire 120 was an aluminum-based nanowire having a laminate structure represented by Formula 7.

The pH of the first mix solution was 8 or higher when measured immediately after preparing the first mix solution. In order to improve the alignment characteristics of the nanowire 120, a weak acid such as acetic acid was added to the first mix solution to adjust the pH of the first mix solution to be within the range of 5 to 7. The first mix solution thus prepared was a polyimide-based resin solution in which the fiber-shape nanowire 120 was dispersed.

The obtained first mix solution was cast. A casting substrate was used for casting. At this time, there is no particular limitation on the type of the casting substrate. The casting substrate may be a glass substrate, a stainless steel (SUS) substrate, a Teflon substrate, or the like. According to one embodiment of the present disclosure, a glass substrate was used as the casting substrate.

Specifically, the obtained first mix solution was applied to a glass substrate and cast. In order to improve the orientation of the nanowire 120, the first mix solution was applied to the glass substrate (casting substrate) and cast while applying a force of 30 N in a direction perpendicular to the glass substrate. As a result, a cast film was produced.

Specifically, the cast film was produced by slowly drying in a hot air oven at 80°C up to 120°C at a rate of 1°C/min for about 40 minutes to maintain the orientation of the nanowire 120. Then, the produced film was peeled off of the glass substrate and fixed to a frame with pins.

The frame to which the optical film was fixed was slowly heated in a vacuum oven from 100°C to 280°C for 2 hours, cooled slowly and separated from the frame to obtain an optical film. The optical film was heated again at 250°C for 5 minutes.

As a result, an optical film 100 having a thickness of 50 µm and including a light-transmitting matrix 110 and a nanowire 120 dispersed in the light-transmitting matrix 110 was completed.

### <Examples 2 to 33>

The optical films 100 were produced under the conditions of Table 1 in the same manner as in Example 1 and were respectively referred to as "Examples 2 to 33". In Table 1, "Formula 7" means an aluminum-based nanowire having a laminate structure represented by Formula 7. "Formula 8" means an aluminum-based nanowire having a laminate structure represented by Formula 8. "Formula 9" means an aluminum-based nanowire having a laminate structure represented by Formula 9.

### <Comparative Examples 1 to 10>

The optical films 100 were produced under the conditions of Table 1 in the same manner as in Example 1 and were respectively referred to as "Comparative Examples 1 to 10".

**[Table 1]**

| Item | Nanowire | | | | |
|---|---|---|---|---|---|
| | Type | Length (nm) | Diameter (nm) | Length/Diam eter | Content (wt%) |
| Example 1 | Formula 7 | 1,600 | 4 | 400 | 10 |
| Example 2 | Formula 7 | 1,600 | 4 | 400 | 1 |
| Example 3 | Formula 7 | 1,600 | 4 | 400 | 5 |
| Example 4 | Formula 7 | 1,600 | 4 | 400 | 20 |
| Example 5 | Formula 7 | 1,600 | 4 | 400 | 30 |
| Example 6 | Formula 7 | 1,600 | 4 | 400 | 40 |
| Example 7 | Formula 8 | 1,600 | 4 | 400 | 1 |
| Example 8 | Formula 8 | 1,600 | 4 | 400 | 5 |
| Example 9 | Formula 8 | 1,600 | 4 | 400 | 10 |
| Example 10 | Formula 8 | 1,600 | 4 | 400 | 20 |
| Example 11 | Formula 8 | 1,600 | 4 | 400 | 30 |
| Example 12 | Formula 8 | 1,600 | 4 | 400 | 40 |
| Example 13 | Formula 9 | 1,600 | 4 | 400 | 1 |
| Example 14 | Formula 9 | 1,600 | 4 | 400 | 5 |
| Example 15 | Formula 9 | 1,600 | 4 | 400 | 10 |
| Example 16 | Formula 9 | 1,600 | 4 | 400 | 20 |
| Example 17 | Formula 9 | 1,600 | 4 | 400 | 30 |
| Example 18 | Formula 9 | 1,600 | 4 | 400 | 40 |
| Example 19 | Formula 7 | 200 | 4 | 50 | 10 |
| Example 20 | Formula 7 | 400 | 4 | 100 | 10 |
| Example 21 | Formula 7 | 800 | 4 | 200 | 10 |
| Example 22 | Formula 7 | 1,200 | 4 | 300 | 10 |
| Example 23 | Formula 7 | 2,000 | 4 | 500 | 10 |
| Example 24 | Formula 8 | 200 | 4 | 50 | 10 |
| Example 25 | Formula 8 | 400 | 4 | 100 | 10 |
| Example 26 | Formula 8 | 800 | 4 | 200 | 10 |
| Example 27 | Formula 8 | 1,200 | 4 | 300 | 10 |
| Example 28 | Formula 8 | 2,000 | 4 | 500 | 10 |
| Example 29 | Formula 9 | 200 | 4 | 50 | 10 |
| Example 30 | Formula 9 | 400 | 4 | 100 | 10 |
| Example 31 | Formula 9 | 800 | 4 | 200 | 10 |
| Example 32 | Formula 9 | 1,200 | 4 | 300 | 10 |
| Example 33 | Formula 9 | 2,000 | 4 | 500 | 10 |
| Comparati ve Example 1 | Not added | - | - | - | - |
| Comparati ve Example 2 | Formula 7 | 1,600 | 4 | 400 | 50 |
| Comparati ve Example 3 | Formula 8 | 1,600 | 4 | 400 | 50 |
| Comparati ve Example 4 | Formula 9 | 1,600 | 4 | 400 | 50 |
| Comparati ve Example 5 | Formula 7 | 20 | 4 | 5 | 10 |
| Comparati ve Example 6 | Formula 8 | 20 | 4 | 5 | 10 |
| Comparati ve Example 7 | Formula 9 | 20 | 4 | 5 | 10 |
| Comparati ve Example 8 | Formula 7 | 4,800 | 8 | 600 | 10 |
| Comparati ve Example 9 | Formula 8 | 4,800 | 8 | 600 | 10 |
| Comparati ve Example 10 | Formula 9 | 4,800 | 8 | 600 | 10 |

### <Measurement example>

The following measurements were performed on the optical films produced in Examples 1 to 33 and Comparative Examples 1 to 10.

### (1) Measurement of elongation (modulus)

The modulus of each of the optical films produced according to Examples 1 to 33 and Comparative Examples 1 to 10 was measured using a universal tensile tester (MODEL 5967) from Instron Corporation in accordance with ASTM D885.
- Criteria of measurement within three hours after film production
- Load Cell 30 kN, Grip 250N.
- Specimen size: 10 mm X 100 mm, tensile speed: 25 mm/min
- Because orientation is created in the direction of coating, the coating direction is called "MD", the direction orthogonal to coating is called "TD", and the measurement was performed in the two directions.

### (2) Measurement of restoration rate (nIT)

According to an embodiment of the present disclosure, the restoration rate (nIT, %) of the optical film 100 may be obtained by calculating the degree of restoration of the optical film 100 in accordance with ISO 14577-1 after removing the optical film 100 which has been pressed with a diamond quadrangular pyramid having a diagonal angle of 136°. The restoration rate of each of the optical films produced according to Examples 1 to 33 and Comparative Examples 1 to 10 was measured using an HM-2000 from Fischer Measurement Technologies.

### (3) Measurement of modulus of elasticity (EIT)

The modulus of elasticity (EIT, indentation modulus) of each of the optical films produced according to Examples 1 to 33 and Comparative Examples 1 to 10 was measured using an HM-2000 from Fischer Measurement Technologies in accordance with ISO 14577-1 and 12 mN/12s/Creep 5s/24°C, 40 RH% conditions.

### (4) Measurement of yellowness index (Y.I.)

The yellowness index of each of the optical films produced according to Examples 1 to 33 and Comparative Examples 1 to 10 was measured using a spectrophotometer (CM-3700D, KONICA MINOLTA) in accordance with the ASTM E313 standard.

### (4) Measurement of haze

The haze of each of the optical films produced according to Examples 1 to 33 and Comparative Examples 1 to 10 was measured by cutting the optical film into specimens with a size of 50 mm x 50 mm, measuring the haze of each specimen 5 times using a haze meter, for example, a haze meter from Murakami Color Laboratories (model name: HM-150) in accordance with ASTM D1003, and calculating an average of the measured five haze values.

### (6) Measurement of light transmittance (%)

The average light transmittance at a wavelength of 360 to 740 nm of each of the optical films produced according to Examples 1 to 33 and Comparative Examples 1 to 10 was measured using a spectrophotometer (CM-3700D, KONICA MINOLTA) .

### <Results of measurement>

The results of measurement of physical properties are shown in Table 2 below.

**[Table 2]**

| Item | Elongation (%) | | | Restora tion rate (nI T, %) | Modulus of elastici ty (EIT, MPa) | Yellow ness index (Y. I.) | Haze (%) | Light transmit tance (%) |
|---|---|---|---|---|---|---|---|---|
| | MD | TD | Aver age | | | | | |
| Example 1 | 29 | 30 | 29.5 | 66.3 | 4,563 | 2.65 | 0.5 | 89.1 |
| Example 2 | 30 | 30 | 30 | 67.4 | 3,920 | 2.59 | 0.2 | 89.2 |
| Example 3 | 30 | 31 | 30.5 | 66.5 | 4,255 | 2.62 | 0.2 | 89.2 |
| Example 4 | 29 | 32 | 30.5 | 66.4 | 4,782 | 2.71 | 0.3 | 88.9 |
| Example 5 | 28 | 25 | 26.5 | 66.1 | 4,911 | 2.88 | 0.6 | 88.6 |
| Example 6 | 21 | 18 | 19.5 | 66.2 | 5,050 | 2.92 | 0.8 | 88.2 |
| Example 7 | 31 | 30 | 30.5 | 67.2 | 3,811 | 2.62 | 0.2 | 89.2 |
| Example 8 | 30 | 28 | 29 | 67.5 | 4,172 | 2.62 | 0.2 | 89.2 |
| Example 9 | 29 | 30 | 29.5 | 66.3 | 4,373 | 2.68 | 0.3 | 89.2 |
| Example 10 | 25 | 22 | 23.5 | 66.5 | 4,681 | 2.77 | 0.6 | 88.8 |
| Example 11 | 17 | 15 | 16 | 66.2 | 4,877 | 2.91 | 0.8 | 88.6 |
| Example 12 | 12 | 11 | 11.5 | 66.2 | 4,953 | 2.92 | 0.8 | 88.5 |
| Example 13 | 28 | 27 | 27.5 | 67.3 | 3, 805 | 2.62 | 0.2 | 89.2 |
| Example 14 | 25 | 25 | 25 | 67.3 | 4, 002 | 2.65 | 0.4 | 89.1 |
| Example 15 | 24 | 26 | 25 | 66.8 | 4,231 | 2.71 | 0.7 | 88.8 |
| Example 16 | 13 | 12 | 12.5 | 66.8 | 4,551 | 2.87 | 1.2 | 88.6 |
| Example 17 | 11 | 9 | 10 | 66.5 | 4,802 | 2.85 | 1.1 | 88.3 |
| Example 18 | 8 | 7 | 7.5 | 66.3 | 4,921 | 2.93 | 1.4 | 88.2 |
| Example 19 | 29 | 29 | 29 | 66.9 | 4,122 | 2.71 | 0.6 | 89.2 |
| Example 20 | 30 | 29 | 29.5 | 66.8 | 4,210 | 2.72 | 0.4 | 89.1 |
| Example 21 | 28 | 27 | 27.5 | 66.2 | 4,421 | 2.67 | 0.4 | 89.2 |
| Example 22 | 29 | 29 | 29 | 66.3 | 4,487 | 2.65 | 0.4 | 89.1 |
| Example 23 | 29 | 29 | 29 | 66.3 | 4,650 | 2.66 | 0.5 | 89 |
| Example 24 | 28 | 28 | 28 | 66.5 | 4,099 | 2.71 | 0.4 | 89.1 |
| Example 25 | 28 | 29 | 28.5 | 66.4 | 4,175 | 2.73 | 0.4 | 89.1 |
| Example 26 | 29 | 29 | 29 | 66.2 | 4,150 | 2.72 | 0.3 | 89.2 |
| Example 27 | 28 | 28.5 | 28.3 | 66.2 | 4,227 | 2.68 | 0.5 | 89.2 |
| Example 28 | 29 | 29 | 29 | 66.3 | 4,402 | 2.81 | 0.6 | 89.1 |
| Example 29 | 25 | 27 | 26 | 66.9 | 3,928 | 2.78 | 0.8 | 88.8 |
| Example 30 | 27 | 27 | 27 | 66.8 | 3,981 | 2.72 | 0.7 | 88.9 |
| Example 31 | 28 | 27 | 27.5 | 66.7 | 4, 092 | 2.66 | 0.7 | 88.9 |
| Example 32 | 26 | 29 | 27.5 | 66.5 | 4,117 | 2.81 | 0.6 | 88.9 |
| Example 33 | 30 | 27 | 28.5 | 66.6 | 4,417 | 2.81 | 0.7 | 88.8 |
| Comparati ve Example 1 | 31 | 30 | 30.5 | 67.6 | 3,710 | 2.61 | 0.2 | 89.2 |
| Comparati ve Example 2 | 13 | 15 | 14 | 65.5 | 5,204 | 3.18 | 1.2 | 87.9 |
| Comparati ve Example 3 | 6 | 5 | 5.5 | 65.1 | 5,100 | 3.21 | 1.1 | 87.9 |
| Comparati ve Example 4 | 3 | 3 | 3 | 65.1 | 5, 024 | 3.19 | 2.5 | 87.3 |
| Comparati ve Example 5 | 30 | 30 | 30 | 66.4 | 3,790 | 3.25 | 1.1 | 88.5 |
| Comparati ve Example 6 | 25 | 22 | 23.5 | 66.3 | 3,751 | 3.32 | 1.5 | 88.4 |
| Comparati ve Example 7 | 17 | 15 | 16 | 66.3 | 3,780 | 3.57 | 1.8 | 88.1 |
| Comparati ve Example 8 | 25 | 20 | 22.5 | 65.9 | 4,111 | 3.71 | 2.2 | 88.3 |
| Comparati ve Example 9 | 17 | 11 | 14 | 65.8 | 4,080 | 3.73 | 2.4 | 88.1 |
| Comparati ve Example 10 | 13 | 13 | 13 | 65.8 | 4,092 | 3.93 | 2.4 | 87.5 |

As can be seen from the results of measurement of Table 2, the optical film 100 according to embodiments of the present disclosure has excellent light transmittance, yellowness index, and haze, and thus has excellent optical properties.

In addition, it can be seen that the optical film 100 according to embodiments of the present disclosure has excellent elongation and restoration rate, as well as superior mechanical properties.

On the other hand, it can be seen that the optical film according to Comparative Example 1 does not include nanowire and thus has poor mechanical properties, particularly, a low modulus of elasticity (EIT), compared to the optical film according to Example.

It can be seen that the optical films according to Comparative Examples 2 to 4 include an excess of nanowires on a weight % basis and have deteriorated optical properties compared to the optical films according to Examples. In particular, it can be seen that the optical films according to Comparative Examples 2 to 4 have higher yellowness index, compared to the optical films according to Examples.

The optical films according to Comparative Examples 5 to 7 include short nanowires. In order to use a predetermined weight ratio, for example, 10% by weight, of nanowires in the optical film, the optical films of Comparative Examples 5 to 7 should use a relatively large number of nanowires compared to the optical films according to Examples. The optical films of Comparative Examples 5 to 7 are considered to have increased haze and increased yellowness due to the use of the relatively large number of nanowires.

The optical films according to Comparative Examples 8 to 10 include very long nanowires. As a result, the optical films of Comparative Examples 8 to 10 are considered to have low optical properties, specifically, high yellowness index.

### [Explanation of reference numerals]

- 100:: Optical film
- 110:: Light-transmitting matrix
- 120:: Nanowire
- 200:: Display device
- 501:: Display panel

## Claims

1. An optical film comprising:
a light-transmitting matrix comprising a polymer resin; and
a nanowire dispersed in the light-transmitting matrix,
wherein the polymer resin comprises at least one of an imide repeating unit and an amide repeating unit, and
the nanowire comprises a crystallite,
wherein the crystallite is linear and the optical film has at least one of structures represented by Formulas 1, 2, and 3 below: 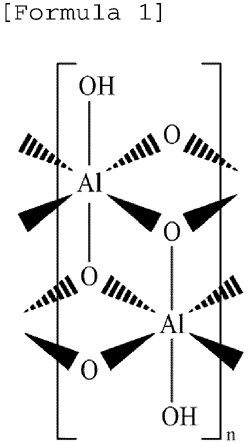 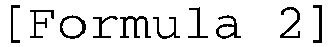 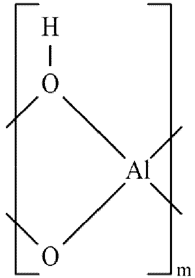 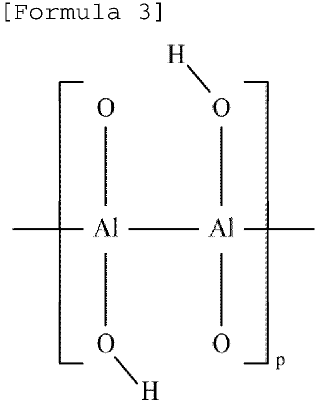
wherein n is in the range of 50 to 10,000,
m is in the range of 50 to 10,000, and
p is in the range of 100 to 20,000.

2. The optical film according to claim 1, wherein the nanowire has a diameter of 2 nm to 10 nm and a length of 200 nm to 4,000 nm.

3. The optical film according to claim 1, wherein the nanowire has a laminate including at least two or more crystallites which are bonded.

4. The optical film according to claim 3, wherein the laminate comprises at least two or more crystallites, and
the crystallites are bonded by a hydrogen bond.

5. The optical film according to claim 3, wherein the laminate comprises 2 to 40 crystallites.

6. The optical film according to claim 3, wherein the laminate comprises at least one of structures represented by the following Formulas 7, 8 and 9.

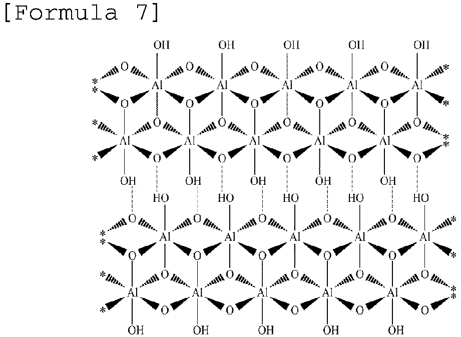

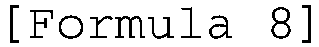

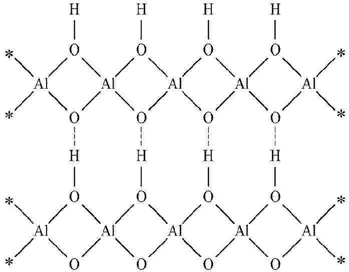

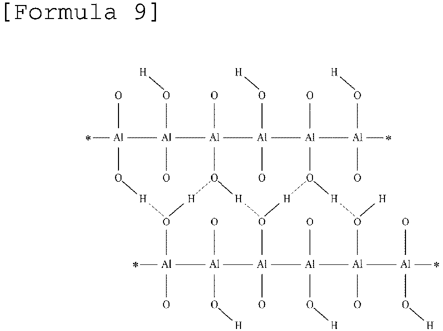

7. The optical film according to claim 1, wherein the nanowire is present in an amount of 1 to 40% by weight based on the total weight of the optical film.

8. The optical film according to claim 1, wherein
n is in the range of 2,000 to 8,000,
m is in the range of 2,000 to 8,000, and
p is in the range of 4,000 to 16,000.

9. The optical film according to claim 1, wherein the optical film has an elongation of 5 to 40%.

10. The optical film according to claim 1, wherein the optical film has a restoration rate (nIT, %) of 66 or more based on a thickness of 50 µm.

11. The optical film according to claim 1, wherein the optical film has a yellowness index of 3 or less.

12. The optical film according to claim 1, wherein the optical film has a haze of 2% or less.

13. The optical film according to claim 1, wherein the optical film has a light transmittance of 88% or more.

14. A display device comprising:
a display panel; and
the optical film according to any one of claims 1 to 13 disposed on the display panel.
